# EUROPÄISCHE PATENTSCHRIFT

(11) **EP 1 945 563 B1**
(45) Veröffentlichungstag und Bekanntmachung des Hinweises auf die Patenterteilung: **31.10.2018**
(21) Anmeldenummer: 06819339.0
(22) Anmeldetag: 08.11.2006
(51) Int. Cl.: B81C 1/00

(54) **IN DER MIKROSYSTEMTECHNIK EINSETZBARES BAUELEMENT SOWIE LÖTVERFAHREN ZUM VERBINDEN ENTSPRECHENDER WAFER- BZW. BAUELEMENT-TEILE**
COMPONENT THAT CAN BE INSERTED USING MICROSYSTEMS TECHNOLOGY, AND SOLDERING METHOD FOR CONNECTING CORRESPONDING WAFER OR COMPONENT PARTS
COMPOSANT POUVANT ETRE EMPLOYE DANS DES MICROSYSTEMES ET PROCEDE DE SOUDAGE DESTINE A LA CONNEXION DE PARTIES CORRESPONDANTES DE PLAQUETTE OU DE COMPOSANT

(30) Priorität: 10.11.2005 DE 102005053722
(43) Veröffentlichungstag der Anmeldung: 23.07.2008
(73) Patentinhaber: Fraunhofer-Gesellschaft zur Förderung der angewandten Forschung e.V., 80686 München (DE)
(72) Erfinder: OLDSEN, Marten, 22761 Hamburg (DE); REINERT, Wolfgang, 24536 Neumünster (DE); MERZ, Peter, 25557 Beldorf (DE)
(74) Vertreter: Strehl Schübel-Hopf & Partner
(86) Internationale Anmeldenummer: PCT/EP2006/068252
(87) Internationale Veröffentlichungsnummer: WO 2007/054524

(56) Entgegenhaltungen:
- EP-A- 0 962 275
- EP-A1- 1 108 677
- EP-B1- 1 501 756
- WO-A-2005/050751
- US-A1- 2003 206 083
- US-A1- 2004 087 043
- US-A1- 2005 082 653

## Beschreibung

Die vorliegende Erfindung ist auf Gegenstände und Verfahren gerichtet, die der Kontrolle der Benetzungsausbreitung von überschüssiger Metallschmelze bei der Verkapselung von Mikrobauteilen, vor allem auf Waferebene, dienen.

Die heutigen mikrosystemtechnischen Bauelemente werden vorzugsweise mit Herstellungsverfahren der Halbleitertechnik gefertigt. Dadurch können kostengünstig viele Bauelemente gleichzeitig hergestellt werden. Diese Bauteile sind jedoch, bedingt durch ihre sehr kleinen Abmessungen, äußerst empfindlich und müssen während des Betriebs bzw. auch schon während der Fertigung gegen äußere Einflüsse geschützt werden. Dies wird bewerkstelligt, indem diese Bauteile durch Schutzkappen hermetisch verschlossen werden.

Verkappungsverfahren sind schon länger bekannt. Oft angewendet wird dabei, dass ein separater Deckelchip (Deckelwafer) auf den die aktiven Strukturen enthaltenen Wafer aufgeklebt oder durch andere Fügeverfahren aufgebracht wird und so die Elemente hermetisch verschlossen werden. Ebenfalls schon länger bekannt sind Verfahren, die den MST-Wafer auf Waferebene verkapseln. Dabei wird ein Wafer, der beispielsweise aus Glas oder Silizium bestehen kann und in der Regel eine oder mehrere Kavitäten zur Aufnahme der aktiven Bauelement-Teile enthält, mittels einer anodischen Verbindung oder durch Einsatz von Glasloten verbunden. Weniger verbreitet in der Waferverbindungstechnik ist der Einsatz von metallischen oder metallhaltigen Loten.

Ein Deckelchip oder Deckelwafer, der durch Löten mit dem die aktiven Strukturen (z.B. Sensoren wie Geschwindigkeits-, Beschleunigungs- oder Drehratensensoren) enthaltenden Wafer verbunden werden soll, besitzt einen Kern, dessen Innenseite (d.h. die dem Wafer mit den aktiven Strukturen zugewandten Seite) ringförmige Bereiche aufweist, die mit entsprechenden Bereichen auf dem Sensoren oder dgl. enthaltenden Wafer verlötet werden sollen. Die entsprechenden Bereiche auf dem die Sensoren oder dgl. enthaltenden Wafer umgeben diese Strukturen, so dass letztere nach dem Verlöten der beiden Wafer in einer Kammer hermetisch abgedichtet sind. Vergleichbares gilt für einzelne Bauteile oder Baulemente, sofern nicht auf Waferebene gearbeitet werden soll. Auch hier ist jedes ein oder mehrere aktive Strukturen enthaltende Bauunterteil (Substrat) über einen ringförmigen Verbindungsbereich mit einem Deckel zu verbinden. Der ringförmige Bereich in einem solchen Deckelteil wird ebenso wie die ringförmigen Bereiche des zuvor erwähnten Deckelwafers nachstehend als ringförmiger Außenbereich bezeichnet.

Das Material für metallische Lote für die genannten Lötverbindungen muss unter Berücksichtigung der Temperaturen ausgewählt werden, die bei der Herstellung der später miteinander zusammenzufügenden Bauelemente auftreten können oder müssen, während das Lotmaterial bereits möglicherweise an der geeigneten Stelle aufgebracht ist. Das Lotmaterial muss also so ausgewählt sein, dass es bei den höchsten für die genannten Verfahrensschritte notwendigen oder erreichten Temperaturen noch nicht schmilzt. Auf der anderen Seite sollte das Lotmaterial bei einer Temperatur schmelzen, die ein Zusammenfügen der Bauteile ermöglicht, ohne dass durch die hierfür notwendigen Temperaturen Schäden an den Teilen auftreten könnten. Als geeignet hat sich hierfür ein Temperaturbereich zwischen etwas oberhalb von 260°C und 450°C erwiesen. In diesem Bereich schmelzen allerdings nur wenige metallische Materialien. Die meisten dieser Materialien enthalten Gold, häufig in Form ihres Eutektikums mit einem anderen Element wie Zinn oder Silicium. Auch zinnbasierte Lote können eingesetzt werden. Insbesondere die AuSi-Verbindungstechnik ist anspruchsvoll, verfügt aber auch über einige wesentliche Vorzüge wie schmale Versiegelungsrahmen, Abdeckungen von Oberflächenstrukturen, hohe Festigkeit und keine Notwendigkeit für eine bauteilseitige Metallisierung. Nachteilig ist jedoch bei der Anwendung der vorgenannten Lotmaterialien die schwierige Kontrolle der Ausbreitung von überschüssigem, sehr dünnflüssigem Lotmaterial. Dieses bildet insbesondere beim Austreten in den/die inneren Hohlraum/Hohlräume kleine Tröpfchen auf den Oberflächen dieser Räume. Da in der Regel das Bauteil beim Löten insgesamt und oft für mehrere Minuten auf der Löttemperatur gehalten wird, fallen oder tropfen diese kleinen Tröpfchen sodann von der Decke der Hohlräume hinunter und können dabei die aktive(n) Struktur(en) des Bauelements beschädigen.

In EP 962 275 A1 wird ein Verfahren zum Lötverbinden von Gehäusen beschrieben, die mikromechanische Elemente enthalten können. Hierfür wird ein lötfähiger Ring rund um das mikromechanische Element auf dem Substrat-Wafer sowie auf dem Kappenwafer aufgebracht, derart, dass die miteinander zu verbindenden Flächen davon bedeckt sind. Gegebenenfalls kann das lötfähige Material auch in der Ausnehmung des Kappenwafers vorhanden sein. Als Lötlegierungen werden vor allem Legierungen mit Zinn vorgeschlagen, da diese niedrige Schmelztemperaturen im Bereich von 180 - 300°C aufweisen.

US 2003/0206083 A1 beschreibt ein Wellenleitermodul mit einem Siliziumsubstrat und einem Glassubstrat, die über Gold-"Bumps" miteinander verbunden sind. Eine metallische Grundschicht wird auf der Innenseite des Glassubstrats strukturiert, die als Microstrip-Filter dient.

US 2004/0087043 A1 betrifft eine Verpackungsstruktur, bei der Substrat und Deckel über Metallschichten miteinander verlötet werden.

Gemäß EP 1 108 677 A1 wird zur Erzeugung eines inneren Hohlraums eine Kupferschicht auf einer später zu opfernden Schicht angebracht.

Aufgabe der vorliegenden Erfindung ist die Vermeidung des Entstehens solcher Tröpfchen und damit die Vermeidung von Schäden an den aktiven Bauteilen beim Lötprozess.

Gelöst wird die Aufgabe durch den Vorschlag, bei einem Deckelwafer bzw. bei einem entsprechenden Bauelement-Deckel in einem Ringbereich innerhalb des oder der ringförmigen Außenbereiche, über den die Bauteile miteinander verlötet werden, ein Puffermaterial vorzusehen, auf dem das eingesetzte Lotmaterial so gut benetzt, dass es zu keiner Tröpfchenbildung kommt. Mit anderen Worten: Die Pufferschicht sollte einen sehr kleinen Benetzungswinkel für Flüssigkeitströpfchen des flüssigen Lotmaterials haben. In der Regel wird ein solches Material zusätzlich eine gewisse Aufnahmekapazität für das flüssige Lotmaterial besitzen, so dass dieses "aufgesogen" wird, was zusätzlich zu dem erwünschten Effekt beiträgt.

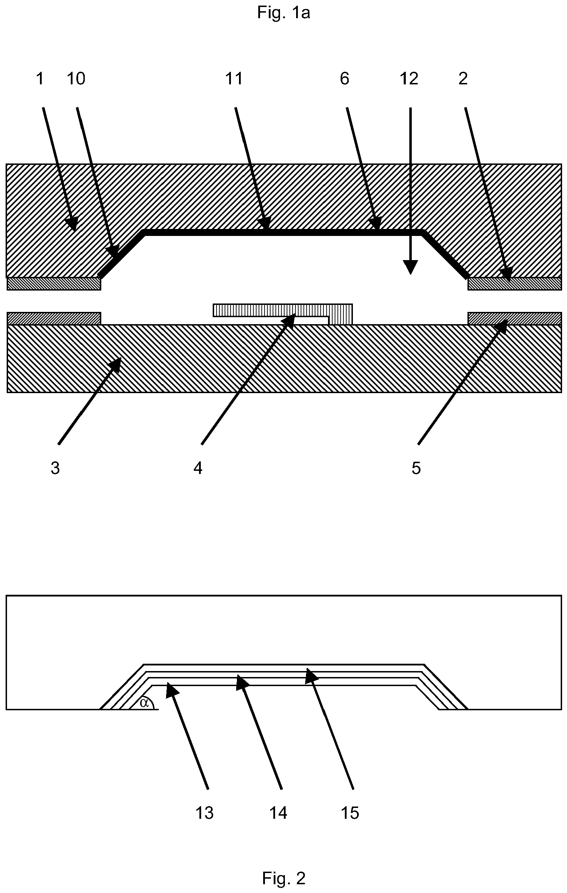

Die Erfindung stellt dementsprechend ein Bauteil gemäß Anspruch 1 und ein Herstellungsverfahren gemäß Anspruch 11 bereit. Spezielle Ausführungsformen sind in den Unteransprüchen offenbart.
Deckelwafer bzw. Deckel können aus einem beliebigen Material, z.B. einem Metall, einer Keramik, Glas oder Silizium oder einem oxidischen Material gebildet sein oder dieses Material als äußerste Schicht aufweisen.
Gleiches gilt für denjenigen Wafer, der als Substrat oder Basis für eine darauf angebrachte aktive Struktur, beispielsweise einen Sensor oder einen Detektor, dient, bzw. für das entsprechende Bauunterteil.
Nachstehend soll die Erfindung anhand der Figuren 1(a) bis 1(c) sowie der Figur 2 näher erläutert werden.
Figur 1a zeigt im Querschnitt einen Ausschnitt aus einem Deckelwafer 1 und einem diesem zugeordneten, aktive Strukturen enthaltenden Wafer ("Sensorwafer") 3. Der Ausschnitt des Sensorwafers zeigt eine aktive, zu schützende Struktur 4, die von einem ringförmigen Außenbereich umgeben ist, auf dem Lotmaterial 5 aufgebracht ist. Der Ausschnitt des Deckelwafers zeigt den entsprechenden Bereich, wobei der ringförmige Außenbereich hier ebenfalls Lotmaterial 2 aufweist. Es sollte klar sein, dass nicht notwendigerweise auf beiden Ringbereichen Lotmaterial vorgelegt werden muss; in der Regel genügt es, dieses Material nur auf einem der beiden Wafer vorzusehen. An den ringförmigen Außenbereich des Deckelwafers schließt sich nach innen ein ringförmiger Bereich 10 sowie ein Innenbereich 11 an. In der dargestellten Ausführungsform sind diese beiden Bereiche als Kavität zur Aufnahme der aktiven Struktur 4 ausgestaltet, wobei der Bereich 10 mit einem Winkel α von der Ebene der Innenseite des Deckels zurückspringt (siehe Fig. 2) und α einen Wert von vorzugsweise 45° bis 90°, stärker bevorzugt von 48° bis 65° und ganz besonders bevorzugt von etwa 54° hat. Es sollte jedoch klar sein, dass statt dessen der Deckelwafer plan oder anders gewölbt sein kann, während die aktive Struktur in einer Vertiefung des Bodenwafers untergebracht ist. Um die kontrollierte Benetzung des in der Verbindung anfallenden metallhaltigen Lotes zu gewährleisten, wird eine Pufferschicht 6 auf den Deckelwafer oder aber auch auf den Sensorwafer zwischen aktiver Struktur und dem ringförmigen Außenbereich aufgebracht. Diese Pufferschicht kann entweder strukturiert, z.B. in Gestalt von radial nach innen weisenden Stegen, oder ganzflächig (als Ring oder den Bereich völlig füllende Fläche) in den Kavitäten des Deckels oder Sensorwafers aufgebracht werden. Sie besteht vorzugsweise aus einem Metall, z.B. aus Gold (und liegt dann bevorzugt in einer Dicke von mindestens 100 nm vor), kann aber auch aus einem Mehrschichtsystem aufgebaut sein. Ein mehrschichtiges System ist in Figur 2 schematisch gezeigt. Es ist vor allem dann ins Auge zu fassen, wenn z.B. ein Haftvermittler 15 und/oder eine Gassperrschicht 14 unter der Puffer-Deckschicht 13 benötigt werden oder deren Vorhandensein zu vorteilhaften Effekten führt.

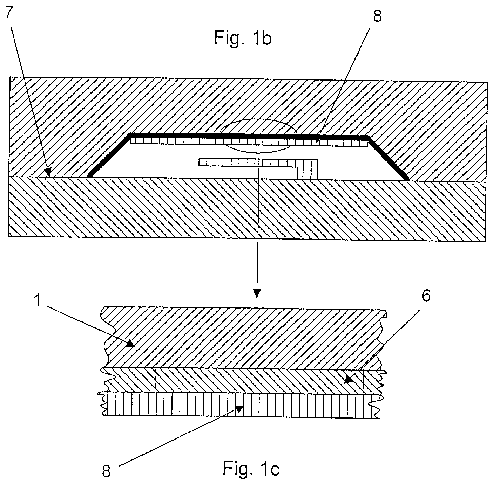

Die beiden genannten Wafer 1 und 3 werden zueinander justiert. Wird nun der Deckelwafer mit dem die aktiven Strukturen enthaltenden Wafer über die jeweiligen ringförmigen Außenbereiche verbunden (der Verbindungsbereich ist in Figur 1b mit 7 bezeichnet), entsteht ein metallisches oder metallhaltiges (z.B. eutektisches AuSi) Lot 8 (siehe Figuren 1b und 1c). Die Pufferschicht nimmt überschüssiges Lot auf und sorgt für eine kontrollierte Benetzung. Ohne Pufferschicht würde sich das Lot auf von Metallen schlecht benetzbaren Oberflächen, wie z.B. oxidischen Oberflächen oder Silizium, unkontrolliert in Klumpen sammeln, die sich auf die Sensorstruktur legen und so einen Ausfall des Bauteils provozieren können.

Soll nicht auf Wafer-Ebene gearbeitet werden, so können einzelne Bauelement-Deckel mit entsprechenden, eine oder mehrere aktive Strukturen aufweisenden Substraten verbunden werden. Die Figuren können für diese Ausführungsvariante als Darstellung von Substraten 3 mit Bauelement-Deckeln 1 gelesen werden, die zu in der Mikrosystemtechnik einsetzbaren Bauelementen verbunden werden können.

Der Vorteil der Integration der erfindungsgemäß vorgesehenen Pufferschicht liegt somit in der Steigerung der Fertigungsausbeute und in der Vermeidung von Ausfällen des Bauteils während des Betriebs, und führt so zu einer kostengünstigeren Produktion von mikrosystemtechnischen hermetisch verkapselten Komponenten.

Die Bereitstellung der Pufferschicht erfolgt in vorteilhafter Weise durch Aufdampfen einer Metallschicht bzw. durch sequentielles Aufdampfen mehrerer Metallschichten. Günstig ist das Vorsehen einer zusätzlich aufgebrachten metallischen Galvanikschicht. Das Aufdampfen kann allseitig erfolgen oder mit Hilfe von geeigneten Masken, wenn strukturierte Schichten gewünscht werden.

Der Benetzungswinkel der Pufferschicht ist in vorteilhafter Weise kleiner 35°; vorzugsweise liegt er unter 12°, und besonders ist er kleiner als 9°.

Die Pufferschicht weist bevorzugt eine metallische Deckschicht 13 auf, wobei das Metall der Deckschicht unter Edelmetallen, insbesondere Gold, Kupfer und Silber, Nickel und Nickellegierungen wie z.B. einer Nickel-/Silberlegierung, und oxidfreien Nichtedelmetallen und Halbmetallen ausgewählt sein kann. Gold ist hierunter besonders bevorzugt.
Befinden sind unter der Deckschicht eine Haftvermittlerschicht 15 und/oder eine Barriereschicht 14, ist es bevorzugt, dass das Material der Schicht unter der Deckschicht unter Wolfram, Titan, Chrom, einer Legierung der vorgenannten Metalle mit einem weiteren Metall, einer Legierung von zweien oder dreien der vorgenannten Metalle, Nickel (unter der Bedingung, dass die Deckschicht nicht ausschließlich aus Nickel gebildet ist), einer Nickellegierung, insbesondere einer Nickel-Vanadium-Legierung, Palladium oder Platin ausgewählt ist. Ganz besonders bevorzugt ist es, dass sich unterhalb der Deckschicht eine Barriereschicht und darunter eine Haftvermittlerschicht befinden. Die nachstehenden Werte sind einzeln bevorzugt: Die Haftvermittlerschicht kann eine Dicke von etwa 5 bis 100, vorzugsweise 20-100 nm haben, die Barriereschicht kann eine Dicke von etwa 30-400 nm haben und die Deckschicht kann eine Dicke von etwa 100nm bis etwa 800 nm, vorzugsweise bis etwa 500 nm haben.
Der oder die ringförmigen Bereiche 10 und/oder der oder die inneren Bereiche 11 können mit einer Getterschicht zum Absorbieren unerwünschter Gase versehen sein, wobei sich die Getterschicht vorzugsweise unterhalb der Pufferschicht oder (direkt) unterhalb der Deckschicht befinden sollte.
In einer spezifischen Ausgestaltung der Erfindung sind auch einige oder alle Außenseiten des Deckelwafers mit einer Deckschicht aus Gold bedeckt.
Nach Verbinden des Deckelwafers mit dem die aktiven Strukturen enthaltenden Wafer können die einzelnen Bauteile daraus abgetrennt werden, was üblicherweise in einer Sägestraße erfolgt.

## Patentansprüche

1. Bauteil, umfassend ein Substrat (3) mit einer Oberseite, die mindestens einen ringförmigen Außenbereich (7) und innerhalb des mindestens einen ringförmigen Außenbereichs (7) angeordnet eine aktive Struktur (4) aufweist, sowie einen Deckel mit einem Kern (1) und einer Innenseite (7,10,11), wobei die Innenseite mindestens einen ringförmigen Außenbereich (7), jeweils einen sich an den mindestens einen Außenbereich nach innen anschließenden ringförmigen Bereich (10) sowie einen Innenbereich (11) umfasst, wobei der mindestens eine ringförmige Außenbereich (7) der Oberseite des Substrats und der mindestens eine ringförmige Außenbereich (7) der Innenseite des Deckel eine zueinander passende Struktur aufweisen und mit Hilfe eines Lotmaterials hermetisch dichtend miteinander verbunden sind, das in einem Temperaturbereich zwischen 265°C und 450°C schmilzt, wobei zumindest der ringförmige Bereich oder die ringförmigen Bereiche (10) des Deckelwafers eine Pufferschicht aufweist/aufweisen, die einen Benetzungswinkel von < 35° für das genannte Lotmaterial besitzt, **dadurch gekennzeichnet, dass** dieses Lotmaterial ein Gold-Silizium-Eutektikum ist.

2. Bauteil nach Anspruch 1 in Form eines Waferbauteils, umfassend ein Substrat mit einer Oberseite, die mehrere ringförmige Außenbereiche und innerhalb eines jeden ringförmigen Außenbereichs (7) angeordnet eine aktive Struktur (4) aufweist, sowie einen Deckel mit einem Kern und einer Innenseite, wobei die Innenseite mehrere ringförmige Außenbereiche und sich an die Außenbereiche nach innen anschließende ringförmige Bereiche (10) sowie Innenbereiche (11) umfasst, wobei die ringförmigen Außenbereiche (7) der Oberseite des Substrats und die ringförmigen Außenbereiche (7) der Innenseite des Deckels eine zueinander passende Struktur aufweisen, wobei das Substrat (3) ein Wafersubstrat ist und der Deckel ein Deckelwafer ist.

3. Bauteil nach Anspruch 1 in Form eines in der Mikrosystemtechnik einsetzbaren Bauelements, worin die Oberseite des Substrats (3) einen ringförmigen Außenbereich (7') und innerhalb des ringförmigen Außenbereichs angeordnet eine aktive Struktur (4) aufweist und worin der Deckel ein Bauelement-Deckel mit einem Kern (1) und einer Innenseite (7,10,11) ist, die einen ringförmigen Außenbereich (7), einen sich an den Außenbereich nach innen anschließenden ringförmigen Bereich (10) sowie einen Innenbereich (11) umfasst.

4. Waferbauteil oder in der Mikrosystemtechnik einsetzbares Bauelement nach einem der Ansprüche 1 bis 3, worin die Pufferschicht als ringsum durchgehende Schicht oder in Form von radial nach innen weisenden Stegen ausgebildet ist.

5. Waferbauteil oder in der Mikrosystemtechnik einsetzbares Bauelement nach einem der Ansprüche 1 bis 4, **dadurch gekennzeichnet, dass** der mindestens eine ringförmige Bereich (10) sowie jeder zugehörige Innenbereich (11) Teile einer Ausnehmung (12) sind.

6. Waferbauteil oder in der Mikrosystemtechnik einsetzbares Bauelement nach einem der Ansprüche 1, 2, 3 oder 5, **dadurch gekennzeichnet, dass** jeder ringförmige Bereich (10) und jeder Innenbereich (11) mit einer durchgehenden Pufferschicht bedeckt sind.

7. Waferbauteil oder in der Mikrosystemtechnik einsetzbares Bauelement nach Anspruch 5, **dadurch gekennzeichnet, dass** der mindestens eine ringförmige Außenbereich (7) der Innenseite im wesentlichen planar ist und der nach innen anschließende ringförmige Bereich (10) als Schräge mit einem Winkel α von 45 bis 90°, vorzugsweise von 54° zu dem ringförmigen Außenbereich (7) ausgebildet ist.

8. Waferbauteil oder in der Mikrosystemtechnik einsetzbares Bauelement nach einem der voranstehenden Ansprüche, **dadurch gekennzeichnet, dass** die Pufferschicht eine metallische Deckschicht (13) aufweist, wobei das Metall der Deckschicht ausgewählt ist unter Edelmetallen, insbesondere Gold, Kupfer und Silber, Nickel und Nickellegierungen, vorzugsweise einer Nickel-/Silberlegierung, und oxidfreien Nichtedelmetallen und Halbmetallen, wobei die Deckschicht ganz besonders bevorzugt aus Gold besteht.

9. Waferbauteil oder in der Mikrosystemtechnik einsetzbares Bauelement nach einem der voranstehenden Ansprüche, **dadurch gekennzeichnet, dass** der Deckelwafer oder der Bauelement-Deckel in dem oder zumindest in einem Teil der Innenbereich(e) (11) der Innenseite und/oder in dem oder zumindest in einem Teil der ringförmigen Bereich(e) (10) der Innenseite eine Getterschicht unterhalb der Pufferschicht oder unterhalb der Deckschicht aufweist.

10. Waferbauteil oder in der Mikrosystemtechnik einsetzbares Bauelement nach einem der voranstehenden Ansprüche, **dadurch gekennzeichnet, dass** auch der mindestens eine ringförmige Außenbereich (7) eine Pufferschicht (2) wie in Anspruch 1 definiert aufweist, die vorzugsweise aus Gold gebildet ist und stärker bevorzugt eine Dicke von mindestens 100 nm aufweist.

11. Verfahren zum Verbinden von zwei in der Mikrosystemtechnik einsetzbaren Wafer- oder Bauelement-Teilen, deren erstes als Bodenwafer oder Substrat (3) und deren zweites als Deckelwafer bzw. Bauelement-Deckel ausgebildet ist, wobei sowohl der Bodenwafer bzw. das Substrat (3) als auch der Deckelwafer bzw. Bauelement-Deckel einander zugewandte, aufeinander passende, ringförmige Außenbereiche (7) aufweisen, **dadurch gekennzeichnet, dass**
- mindestens eines der beiden Teile in einem Zustand bereitgestellt wird, in dem sich ein Lotmaterial (2; 5) auf dem oder allen ringförmigen Außenbereichen (7) befindet, das einen Schmelzpunkt im Bereich zwischen 265°C und 450°C besitzt und dass zumindest das als Deckelwafer bzw. Bauelement-Deckel dienende Teil in sich an den Außenbereich nach innen anschließenden ringförmigen Bereichen (10) mit einer Pufferschicht versehen ist, die einen Benetzungswinkel von < 35° für das genannte Lotmaterial in flüssigem Zustand besitzt, und
- die beiden Teile bei einer Temperatur von über 265 bis 450°C unter Ausbildung eines Gold-Silizium-Eutektikums miteinander verbunden werden.

12. Verfahren nach Anspruch 11, worin die Pufferschicht als durchgehende Schicht oder in Form von radial nach innen weisenden Stegen ausgebildet ist.

13. Verfahren nach Anspruch 11 oder 12, weiterhin umfassend das Vereinzeln einer Mehrzahl der durch das Verbinden erzeugten Bauelemente.

## Claims

1. A component comprising a substrate (3) with a top which has at least one annular outside region (7) and an active structure (4) arranged within the annular outer region (7), and a cover having a core (1) and an inside (7, 10, 11), wherein the inside comprises at least one annular outer region (7), annular region(s) (10) each of which adjoins the at least one outer regions to the inside, and an inner region (11), wherein the at least one annular outside region (7) of the upper side of the substrate and the at least one annular outside region (7) of the inside of the cover have a structure which matches one another and are connected to one another hermetically using a solder material which melts in the temperature range between 265°C and 450°C, at least the annular region(s) (10) of the cover wafer having a buffer layer having a wetting angle of <35°C for the whole solder material, **characterized in that** the solder material is a gold-silicon-eutectic.

2. The component according to claim 1 in the form of a wafer component, comprising a substrate having a top which has several annular outside regions and an active structure (4) arranged within each of the annular outside regions (7), as well as a cover having a core and an inside, wherein the inside comprises several annular outside regions and annular regions (10) adjoining the outside regions to the inside, as well as inside regions (11), wherein the annular regions (7) of the inside of the cover have a structure matching one another, wherein the substrate (3) is a wafer substrate and the cover is a cover wafer.

3. The component according to claim 1 in the form of a component that can be used in microsystem technology, wherein the top of substrate (3) comprises an annular outside region (7') and an active structure (4) arranged within the annular outside region, and wherein the cover is a component cover having a core (1) and an inside (7,10,11) comprising an annular region (10) adjoining the outside region to the inside as well as an inner region (11).

4. The wafer component or the component usable in microsystem technology according to any one of claims 1 to 3, wherein the buffer layer is made as a layer which is peripherally continuous or in the form of webs which point radially to the inside.

5. The wafer component or the component usable in microsystem technology according to any one of claims 1 to 4, **characterized in that** the annular region (10) or each annular region (10) and each pertinent inner region (11) are parts of a recess (12).

6. The wafer component or the component usable in microsystem technology according to any one of claims 1, 2, 3 or 5, **characterized in that** each annular region (10) and each inner region (11) are covered with a continuous buffer layer.

7. The wafer component or the component usable in microsystem technology according to claim 5, **characterized in that** the at least one annular outer region (7) of the inside is essentially planar and the annular region (10) is made as a bevel with an angle α of 45 to 90°, preferably 54° to the annular outer region (7) .

8. The wafer component or the component usable in microsystem technology according to any one of the preceding claims, **characterized in that** the buffer layer has a metallic cover layer (13), wherein the metal of the cover layer is selected from a precious metal, in particular gold, copper and silver, nickel and nickel alloys, preferably a nickel/silver alloy, oxide-free non-precious metal or semi-metal, wherein the cover layer particularly preferably consists of gold.

9. The wafer component or the component usable in microsystem technology according to any one of the preceding claims, **characterized in that** the cover wafer or the component cover in the or in at least in a part of the inner region(s) (11) of the inside and/or in the or at least in a part of the annular region(s) (10) of the inside has a getter layer underneath the buffer layer or underneath the cover layer.

10. The wafer component or the component usable in microsystem technology according to any one of the preceding claims, **characterized in that** the at least one annular outside region (7) also has a buffer layer (2) as defined in claim 1, which is preferably formed of gold and more preferably has a thickness of at least 100 nm.

11. A method for connecting two wafer parts or component parts which can be used in microsystems technology, having a first part made as a bottom wafer or substrate (3) and having a second part made as a cover wafer or component cover, both the bottom wafer and the substrate (3) as well as the cover wafer or component cover having annular outer regions (7) which match one another and which face one another, **characterized in that**
- at least one of the two parts is prepared in a state in which the solder material (2; 5) is located on the annular outer region (7) or all annular outer regions (7), which has a melting point in the range between 265°C and 450°C, and that at least the part which is used as a cover wafer or component cover is provided in the annular regions (10) which adjoin the outer region to the inside with a buffer layer which has a wetting angle of <35° for the solder material in the liquid state, and
- the two parts are connected to one another at a temperature of more than 265 to 450°C thereby forming a gold-silicon-eutectic.

12. The method according to claim 11, wherein the buffer layer is made as a continuous layer or in the form of webs which point radially to the inside.

13. The method according to claim 11 or 12, furthermore comprising the separation of a plurality of the components which have been produced by bonding.

## Revendications

1. Composant, comprenant un substrat (3) avec un côté supérieur, qui présente au moins une zone extérieure annulaire (7) et une structure active (4) disposée à l'intérieur de la zone extérieure annulaire (7), ainsi qu'un couvercle avec un noyau (1) et un côté intérieur (7, 10, 11), dans lequel le côté intérieur comprend au moins une zone extérieure annulaire (7), respectivement une zone annulaire (10) se joignant vers l'intérieur à ladite au moins une zone extérieure ainsi qu'une zone intérieure (11), dans lequel ladite au moins une zone extérieure annulaire (7) du côté supérieur du substrat et ladite au moins une zone extérieure annulaire (7) du côté intérieur du couvercle présentent une structure adaptée l'une à l'autre et sont hermétiquement assemblées l'une à l'autre à l'aide d'un matériau de brasage, qui fond dans une plage de température de 265°C à 450°C, dans lequel au moins la zone annulaire ou les zones annulaires (10) de la plaquette de couvercle présente(nt) une couche tampon, qui a un angle de mouillage < 35° pour le matériau de brasage précité, **caractérisé en ce que** ce matériau de brasage est un eutectique or-silicium.

2. Composant selon la revendication 1 sous la forme d'un composant de plaquette, comprenant un substrat avec un côté supérieur, qui présente plusieurs zones extérieures annulaires et une structure active (4) disposée à l'intérieur de chaque zone extérieure annulaire (7), ainsi qu'un couvercle avec un noyau et un côté intérieur, dans lequel le côté intérieur comprend plusieurs zones extérieures annulaires et plusieurs zones annulaires (10) se joignant vers l'intérieur aux zones extérieures ainsi que des zones intérieures (11), dans lequel les zones extérieures annulaires (7) du côté supérieur du substrat et les zones extérieures annulaires (7) du côté intérieur du couvercle présentent une structure adaptée l'une à l'autre, dans lequel le substrat (3) est un substrat de plaquette et le couvercle est une plaquette de couvercle.

3. Composant selon la revendication 1 sous la forme d'un composant pouvant être employé dans la technique des microsystèmes, dans lequel le côté supérieur du substrat (3) présente une zone extérieure annulaire (7') et une structure active (4) disposée à l'intérieur de la zone extérieure annulaire et dans lequel le couvercle est un couvercle de composant avec un noyau (1) et un côté intérieur (7, 10, 11), qui comprend une zone extérieure annulaire (7), une zone annulaire (10) se joignant vers l'intérieur à la zone extérieure ainsi qu'une zone intérieure (11).

4. Composant de plaquette ou composant pouvant être employé dans la technique des microsystèmes selon l'une quelconque des revendications 1 à 3, dans lequel la couche tampon est réalisée sous la forme d'une couche continue tout autour ou sous la forme de nervures tournées radialement vers l'intérieur.

5. Composant de plaquette ou composant pouvant être employé dans la technique des microsystèmes selon l'une quelconque des revendications 1 à 4, **caractérisé en ce que** ladite au moins une zone annulaire (10) ainsi que chaque zone intérieure correspondante (11) sont des parties d'un évidement (12).

6. Composant de plaquette ou composant pouvant être employé dans la technique des microsystèmes selon l'une quelconque des revendications 1, 2, 3 ou 5, **caractérisé en ce que** chaque zone annulaire (10) et chaque zone intérieure (11) sont couvertes par une couche tampon continue.

7. Composant de plaquette ou composant pouvant être employé dans la technique des microsystèmes selon la revendication 5, **caractérisé en ce que** ladite au moins une zone extérieure annulaire (7) du côté intérieur est essentiellement plane et la zone annulaire (10) se joignant vers l'intérieur est réalisée sous forme inclinée avec un angle α de 45 à 90°, de préférence de 54°, par rapport à la zone extérieure annulaire (7).

8. Composant de plaquette ou composant pouvant être employé dans la technique des microsystèmes selon l'une quelconque des revendications précédentes, **caractérisé en ce que** la couche tampon présente une couche de recouvrement métallique (13), dans lequel le métal de la couche de recouvrement est choisi parmi les métaux nobles, en particulier l'or, de cuivre et l'argent, le nickel et des alliages de nickel, de préférence un alliage nickel/argent, et des métaux non nobles sans oxydes et des métalloïdes, dans lequel la couche de recouvrement est de préférence constituée d'or.

9. Composant de plaquette ou composant pouvant être employé dans la technique des microsystèmes selon l'une quelconque des revendications précédentes, **caractérisé en ce que** la plaquette de couvercle ou le couvercle de composant présente dans la ou au moins dans une partie de la/des zone(s) intérieure(s) (11) du côté intérieur et/ou dans la ou au moins dans une partie de la/des zone(s) annulaire(s) (10) du côté intérieur une couche de piégeage en dessous de la couche tampon ou en dessous de la couche de recouvrement.

10. Composant de plaquette ou composant pouvant être employé dans la technique des microsystèmes selon l'une quelconque des revendications précédentes, **caractérisé en ce que** ladite au moins une zone extérieure annulaire (7) présente également une couche tampon (2) telle qu'elle a été définie dans la revendication 1, qui est de préférence formée d'or et qui présente de préférence encore une épaisseur d'au moins 100 nm.

11. Procédé pour assembler deux parties de plaquette ou de composant pouvant être employées dans la technique des microsystèmes, dont la première est réalisée sous la forme de plaquette de fond ou de substrat (3) et dont la seconde est réalisée sous la forme de plaquette de couvercle ou de couvercle de composant, dans lequel aussi bien la plaquette de fond ou le substrat (3) que la plaquette de couvercle ou le couvercle de composant présentent des zones extérieures annulaires (7) tournées l'une vers l'autre et adaptées l'une à l'autre, **caractérisé en ce que**
- on prépare au moins une des deux parties dans un état dans lequel il se trouve sur la ou sur toutes les zones extérieures annulaires (7) un matériau de brasage (2; 5), qui possède un point de fusion compris entre 265°C et 450°C et **en ce qu'**au moins la partie servant de plaquette de couvercle ou de couvercle de composant est munie dans des zones annulaires (10) se joignant vers l'intérieur à la zone extérieure d'une couche tampon, qui a un angle de mouillage de < 35° pour le matériau de brasage précité à l'état liquide, et
- on assemble les deux parties l'une à l'autre à une température de plus de 265 à 450°C avec formation d'un eutectique or-silicium.

12. Procédé selon la revendication 11, dans lequel la couche tampon est réalisée sous la forme d'une couche continue ou sous la forme de nervures orientées radialement vers l'intérieur.

13. Procédé selon la revendication 11 ou 12, comprenant en outre la séparation d'une multiplicité des composants produits par l'assemblage.
